# EUROPÄISCHE PATENTSCHRIFT

(11) **EP 2 057 738 B1**
(45) Veröffentlichungstag und Bekanntmachung des Hinweises auf die Patenterteilung: **12.03.2014**
(21) Anmeldenummer: 07802455.1
(22) Anmeldetag: 01.08.2007
(51) Int. Cl.: H03K 17/96, H01H 13/70

(54) **BEDIENEINRICHTUNG FÜR EIN HAUSHALTSGERÄT MIT ZUMINDEST EINER KAPAZITIVEN SENSORTASTE**
CONTROL DEVICE FOR A HOUSEHOLD APPLIANCE COMPRISING AT LEAST ONE CAPACITIVE SENSOR KEY
DISPOSITIF DE COMMANDE POUR APPAREIL MÉNAGER, COMPORTANT AU MOINS UNE TOUCHE À EFFLEUREMENT CAPACITIVE

(30) Priorität: 21.08.2006 DE 102006039133
(43) Veröffentlichungstag der Anmeldung: 13.05.2009
(73) Patentinhaber: BSH Bosch und Siemens Hausgeräte GmbH, 81739 München (DE)
(72) Erfinder: ENZENHÖFER, Günter, 90478 Nürnberg (DE); KLEINLEIN, Herbert, 90522 Oberasbach (DE); MENTEN, Frank, 93055 Regensburg (DE)
(86) Internationale Anmeldenummer: PCT/EP2007/057933
(87) Internationale Veröffentlichungsnummer: WO 2008/022883

(56) Entgegenhaltungen:
- EP-A- 1 257 057
- EP-A- 1 672 797
- WO-A-2005/043760
- WO-A-2005/101663

## Beschreibung

Die Erfindung bezieht sich auf eine Bedieneinrichtung für ein Haushaltsgerät mit zumindest einer kapazitiven Sensortaste, wobei die Sensortaste ein elektrisch leitfähiges Sensorelement mit einer Sensorfläche aufweist, mit der dieses Sensorelement an einer Rückseite einer elektrisch isolierenden Abdeckplatte der Bedieneinrichtung anliegt, wobei in einem Abstand von der Abdeckplatte eine Leiterplatte angeordnet ist, und wobei sich das Sensorelement von der Abdeckplatte bis zu der Leiterplatte erstreckt.

Es sind bereits zahlreiche Vorrichtungen mit kapazitiven Sensortasten oder Schaltern bekannt. Bei einer speziellen Bauart dieser kapazitiven Sensortasten, ist eine elektrisch leitende Sensorfläche von einer elektrisch isolierenden Abdeckplatte abgedeckt. Ein Benutzer berührt also die Sensorfläche nicht direkt, sondern nähert sich ihr bei Berührung der Abdeckplatte lediglich an. Die Sensorfläche bildet eine Platte eines offenen Kondensators, dessen Kapazität von dem Abstand zu einer zweiten Platte (z.B. Erde) abhängt, der beispielsweise durch Annäherung eines Fingers des Benutzers verändert wird.

Die vorliegende Erfindung bezieht sich auf eine spezielle Bauart von kapazitiv wirkenden Sensortasten, bei der die Leiterplatte mit der Sensorschaltung an der Rückseite der Abdeckplatte in einem Abstand zu derselben angeordnet ist. Um die sensorische Fühlereigenschaft von der Leiterplatte an die Abdeckplatte zu verlegen, ist in diesem Fall ein elektrisch leitfähiges Sensorelement zwischen der Abdeckplatte und der Leiterplatte angeordnet, das mit der Sensorschaltung elektrisch verbunden ist, das den Abstand zwischen Leiterplatte und Abdeckplatte überbrückt, und das eine Sensorfläche aufweist, mit der es an der Rückseite der Abdeckplatte anliegt.

Eine solche Bedieneinrichtung mit einer kapazitiven Sensortaste ist bereits aus EP 1 030 536 B1 bekannt. Dort ist ein Sensorelement gezeigt, das aus einem dünnen Metallblech besteht und neben einer eben ausgebildeten Sensorfläche starre Steck- oder Standbeine aufweist, mit denen das Sensorelement an einer Leiterplatte angelötet ist.

Aus EP 0 780 865 B1 ist ein Sensorelement bekannt, welches über mehrere Anschlussfahnen in Bohrungen einer Leiterplatte eingesetzt und dort mit Leiterbahnen der Leiterplatte verschweißt oder verlötet wird.

Eine andere solche Bedieneinrichtung ist aus EP-A-1 672 797 bekannt.

Der vorliegenden Erfindung liegt die Aufgabe zugrunde, eine verbesserte, kostengünstige Bedieneinrichtung mit einer kapazitiven Sensortaste zur Verfügung zu stellen, welche besonders einfach, schnell und funktionssicher montierbar ist.

Gelöst wird die vorstehend aufgezeigte Aufgabe durch eine Bedieneinrichtung mit den Merkmalen des Anspruchs 1. Vorteilhafte sowie bevorzugte Ausgestaltungen der Erfindung sind Gegenstand der abhängigen Ansprüche.

Diese Bedieneinrichtung ist mit zumindest einer kapazitiven Sensortaste ausgebildet, wobei die Sensortaste ein elektrisch leitfähiges Sensorelement mit einer Sensorfläche aufweist, mit der dieses Sensorelement an einer Rückseite einer elektrisch isolierenden Abdeckplatte der Bedieneinrichtung anliegt, wobei in einem Abstand von der Abdeckplatte eine Leiterplatte angeordnet ist, und wobei sich das Sensorelement von der Abdeckplatte bis zu der Leiterplatte erstreckt. D.h. das Sensorelement ist einstückig ausgebildet und weist zwei Bereiche auf, wobei der erste Bereich die Sensorfläche bildet und wobei der zweite Bereich dazu dient die Sensorfläche mit der Leiterplatte elektrisch leitfähig zu verbinden. Erfindungsgemäß ist zwischen der Abdeckplatte und der Leiterplatte ein Lichtkasten angeordnet, durch den das Sensorelement in einer vorgegebenen Position an der Rückseite der Abdeckplatte parallel und senkrecht zu der Abdeckplatte fixiert ist. Die vorgegebene Position des Sensorelements korreliert eindeutig mit der Position der Sensorfläche an der Rückseite der Abdeckplatte und somit mit der Position der Sensortaste.

Durch die Fixierung des Sensorelement durch bzw. mit Hilfe des Lichtkastens ist das Sensorelement gegen etwaige Verschiebungen aus der vorgegebenen Position in beliebige Raumrichtungen gesichert. Auf diese Weise kann eine Befestigung des Sensorelements auf der Leiterplatte vermieden werden, insbesondere eine Verlötung oder Verschweißung des Sensorelements mit Leiterbahnen der Leiterplatte. Somit hat die Erfindung insbesondere den Vorteil, dass eine Bestückung der Leiterplatte mit dem Sensorelement eingespart werden kann, wodurch sich die Fertigungskosten der Bedieneinrichtung deutlich reduzieren.

Gemäß einer bevorzugten Ausführungsform ist an dem Lichtkasten zumindest eine Halterung für das Sensorelement ausgebildet, mit der das Sensorelemente gehaltert ist. Vorzugsweise ist die Fixierung des Sensorelements allein durch diese an dem Lichtkasten ausgebildete Halterung realisiert. Auf diese Weise wird das Herstellungsverfahren der Bedieneinrichtung besonders vereinfacht, da das Sensorelement an dem Lichtkasten, der vorzugsweise ein Kunststoffspritzgussteil ist, vormontiert werden kann. Besonders einfach ist die Vormontage des Sensorelements an dem Lichtkasten dann möglich, wenn die Halterung ein Rastelement ist oder aufweist, mit dem das Sensorelement verrastet werden kann.

Gemäß einer weiteren bevorzugten Ausführungsform ist die Fixierung des Sensorelements durch Zusammenwirken des Lichtkastens mit der Abdeckplatte realisiert. Vorteilhafterweise ist dafür an der Rückseite der Abdeckplatte ein Positionierelement zur Lagesicherung des Sensorelements ausgebildet ist, so dass die Position des Sensorelements durch das Positionierelement bezüglich zumindest einer Translationsrichtung parallel zu der Abdeckplatte festgelegt ist. Die Position des Sensorelements bezüglich verbleibender Translationsfreiheitsgrade parallel oder senkrecht zur Abdeckplatte wird dann durch den Lichtkasten festgelegt, so dass eine Verschiebung des Sensorelements in keine Richtung mehr möglich und das Sensorelement an der Rückseite der Abdeckplatte fixiert ist.

Vorzugsweise ist das Positionierelement derart ausgebildet, dass es das Sensorelement zumindest teilweise umrahmt. Es sind aber auch andere Formen des Positionierelements möglich, wie beispielsweise ein Positionierstift, auf den das Sensorelement gesteckt oder ein Rastelement, mit dem das Sensorelement verrastet werden kann.

Der Lichtkasten dient also vorteilhaft dazu, die Anordnung des wenigstens einen Sensorelements insbesondere relativ zur Bedienblende festzulegen. Damit wird auch die Lage des zweiten Bereichs des Sensorelements relativ genau bestimmt, der dazu dient die Sensorfläche mit der Leiterplatte elektrisch leitfähig zu verbinden. Dieses freie Ende des Sensorelements kontaktiert die Leiterplatte, indem die Leiterplatte relativ zu dem Lichtkasten ausgerichtet bzw. fixiert wird. Da die elektrische Anbindung des Sensorelements an die Leiterplatte bereits durch diesen losen Druckkontakt erfolgt, ist eine separate elektrische Anbindung durch beispielsweise Löten oder Anklemmen nicht erforderlich.

Eine besonders einfache und kostengünstige Montage der Bedieneinrichtung ist möglich, wenn für die Verbindung der Einzelteile geeignete Rastmechanismen vorgesehen sind. Insbesondere können der Lichtkasten und die Abdeckplatte und/oder der Lichtkasten und die Leiterplatte und/oder die Leiterplatte und die Abdeckplatte durch eine Rastverbindung miteinander verbunden werden.

Beispielsweise kann der Lichtkasten in einem ersten Montageschritt mit der Abdeckplatte verbunden werden, wobei das zwischen dem Lichtkasten und der Abdeckplatte angeordnete Sensorelement lagerichtig fixiert wird. In einem anschließenden Montagevorgang, bei dem lediglich die Leiterplatte noch mit dem Lichtkasten bzw. der Abdeckplatte in Verbindung gebracht werden muss, entsteht dann zwangsläufig und ohne Weiteres der elektrische Kontakt zwischen dem Kontaktbereich des an sich bereits fixierten Sensorelements und der Leiterplatte.

In einer alternativen Ausführungsform kann in einem ersten Montageschritt das Sensorelement an dem Lichtkasten fixiert werden. In einem zweiten Montageschritt wird der Lichtkasten mit der Leiterplatte verbunden, beispielsweise durch eine Rastverbindung, wodurch der elektrische Kontakt zwischen Sensorelement und Leiterplatte hergestellt wird. In einem letzten Montageschritt wird dann diese vormontierte Baugruppe mit der Abdeckplatte verbunden, vorzugsweise wieder mit einer Rastverbindung. Diese Rastverbindung mit der Abdeckplatte kann entweder mit dem Lichtkasten oder mit der Leiterplatte realisiert sein.

Gemäß einer bevorzugten Ausführungsform ist an der Abdeckplatte ein Montagerahmen angeformt, an dem der Lichtkasten und/oder die Leiterplatte mittels Rastverbindung montiert ist. Dieser Montagerahmen kann beispielsweise an der Abdeckplatte angespritzt sein, insbesondere durch ein Zweikomponenten-Spritzgussverfahren. An diesem Montagerahmen können auf einfache Art und Weise die Rastelemente für die Rastverbindungen mit dem Lichtkasten und/oder der Leiterplatte ausgebildet sein, insbesondere in Form von Rasthaken, Rastnasen, Rastösen oder Gegenrastlager. Bei komplettierter Bedieneinrichtung kann durch die Abdeckplatte, den Montagerahmen und die Leiterplatte ein geschlossenes Gehäuse gebildet sein, das die Elektronikkomponenten der Bedieneinrichtung beinhaltet und gegenüber möglichen Umwelteinflüssen schützt, wie beispielsweise Schmutz oder Feuchtigkeit. Dieses Gehäuse weist eventuell lediglich Öffnungen für elektrische Anschlüsse der Leiterplatte auf.

Ein wesentliches Merkmal der vorliegenden Erfindung besteht darin, dass das Sensorelement lediglich über Druckspannung an einer Berührkontaktfläche der Leiterplatte anzuliegen braucht. Vorzugsweise ist das Sensorelement dafür elastisch ausgebildet. So lässt sich der elektrische Kontakt zwischen dem Sensorelement und einer nachgeordneten Steuerung mittels der Leiterplatte einfach dadurch erzielen, dass die Leiterplatte gegen den geeignet ausgebildeten Kontaktbereich des Sensorelements gedrückt wird. Dies geschieht automatisch beim Zusammenbau der Bedieneinrichtung, ohne dass dabei spezielle Löt- oder sonstige elektrische Verbindungsarbeiten vorzunehmen wären. Eine vorgebbare Andruckkraft, mit der der Kontaktbereich des Sensorelements gegen die Leiterplatte bzw. einen darauf ausgebildeten Kontakt drückt, sichert dabei die elektrische Verbindung, die vorteilhafterweise durch Entfernen der Leiterplatte oder Abziehen des Lichtkastens und/oder der Abdeckplatte mit an der Rückseite angeordnetem Sensorelement ebenso leicht wieder lösbar ist. Dadurch ergibt sich in vorteilhafter Weise eine sehr einfache Montage der Bedieneinrichtung mit einem oder auch mehreren Sensorelementen.

Vorzugsweise ist das Sensorelement derart ausgebildet, dass die Sensorfläche formschlüssig an der Rückseite der Abdeckplatte anliegt, insbesondere auch bei gekrümmten Abdeckplatten. Beispielsweise ist das Sensorelement eine metallische Blattfeder oder eine aus einem gestreckten Körper gewundene Druckfeder oder ein elastischer Körper aus Leitgummi. Eventuell kann das Sensorelement auch eine metallische Blattfeder sein, die zumindest im Bereich der Sensorfläche mit einem elastischen, insbesondere elektrisch leitfähigem Material, wie zum Beispiel Leitgummi, beschichtet ist, damit das Sensorelement mit dieser beschichteten Sensorfläche einen verbesserten Formschluss mit der Rückseite der Abdeckplatte bilden kann. Im einfachsten Fall ist die Sensorfläche eine rechteckige oder quadratische Fläche, die zur Ausbildung einer geeigneten Sensitivität metallisch ausgebildet sein kann, aber nicht sein muss.

Der Kontaktbereich des erfindungsgemäßen Sensorelements, der dazu dient, die von der Abdeckplatte beabstandete Leiterplatte elektrisch zu kontaktieren, kann in Form wenigstens eines Kontaktelements ausgebildet sein, das sich von der Sensorfläche bis zu der Leiterplatte erstreckt. Zur Kontaktierung der Leiterplatte kann auf der Leiterplatte zumindest eine elektrisch leitfähige, insbesondere metallische Berührkontaktfläche ausgebildet sein. Das Kontaktelement des Sensorelements ist auf der Leiterplatte jedoch in keiner Weise fixiert. Erfindungsgemäß ist das Sensorelement oder zumindest das Kontaktelement derart federnd ausgebildet, dass das Kontaktelement bei Anordnung des Sensorelements in einem vorgebbaren Abstand zur Leiterplatte mit einer bestimmten Andruckkraft gegen die Leiterplatte drückt und dadurch einen sicheren, jedoch leicht herstellbaren bzw. lösbaren elektrischen Kontakt aufbaut. Durch die federnde Wirkung kann das Kontaktelement Montagetoleranzen ausgleichen. Zum andern gewährleistet die federnde Wirkung eine sichere Anbindung an die entsprechende Berührkontaktfläche der Leiterplatte.

Nach einer besonders vorteilhaften Ausführungsform der Erfindung weist das Sensorelement einen eben ausgebildeten Abschnitt auf, durch den die Sensorfläche definiert ist, und zu dem das Kontaktelement, das im Wesentlichen geradlinig ausgebildet ist, unter einem spitzen Winkel angeordnet ist. Insbesondere ist das Kontaktelement federnd zu dem ebenen Abschnitt ausgebildet. Diese Gestalt ist besonders einfach und kostengünstig herzustellen. Je nach Anbindung des Kontaktelements an den ebenen Abschnitt des Sensorelements bzw. Anzahl und Form der Kontaktelemente selbst, lässt sich die Andruckkraft vorgeben, mit der das untere freie Ende des Kontaktelements auf die Leiterplatte drückt. In Fortführung dieses Gedankens kann der ebene Abschnitt zusammen dem Kontaktelement in Form einer metallischen Blattfeder einstückig ausgebildet sein. Insbesondere ist das Kontaktelement oder sind die Kontaktelemente an einem Randbereich des ebenen Abschnitts angeordnet.

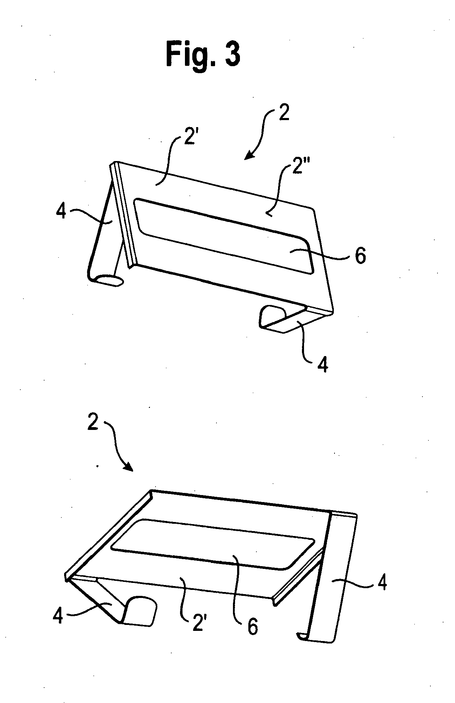

Ein solches Sensorelement mit Kontaktelement (wie insbesondere die Fig. 3 zeigt) lässt sich sehr einfach, beispielsweise durch einen Stanzvorgang herstellen. Das wenigstens eine Kontaktelement kann dabei als Extremität des Sensorelements mit diesem zunächst in einer Ebene ausgebildet sein, um nach dem Ausstanzen so umgebogen zu werden, dass es als Federkontakt mit der Leiterplatte zusammenwirken kann. Das (im eingebauten Zustand auf der Leiterplatte aufliegende) freie Ende eines solchen Kontaktelements ist in seiner Lage in zwei Richtungen (also in der Ebene parallel zum ebenen Abschnitt des Sensorelements) im Wesentlichen genau definiert, lediglich die Position in der AndruckRichtung ist aufgrund der Federwirkung gewollt toleranzbehaftet. Damit lässt sich die zugeordnete Kontaktfläche auf der Leiterplatte gezielt kontaktieren, ohne dass ein seitlicher Versatz zu befürchten wäre. Insbesondere kann das Kontaktelement dazu dienen, das Sensorelement an dem Lichtkasten zu haltern und/oder zu fixieren, indem es beispielsweise in Rastöffnungen des Lichtkastens eingerastet wird. Alternativ oder zusätzlich dazu, kann der ebene Abschnitt dazu dienen, das Sensorelement an der Abdeckplatte zu positionieren oder an dem Lichtkasten zu haltern. Vorzugsweise ist das Sensorelement mit zwei Kontaktelementen ausgebildet, die an gegenüberliegenden Randbereichen des ebenen Abschnitts angeordnet sind.

Vorzugsweise ist die Abdeckplatte zumindest teilweise lichtdurchlässig ausgebildet, und auf der Leiterplatte ist im Bereich der Sensorfläche ein optisches Anzeigeelement angeordnet. Insbesondere weist das Sensorelement zumindest einen Durchlass für Licht des Anzeigeelements auf. Insbesondere ist der Durchlass derart ausgebildet, dass die Sensorfläche des Sensorelements das Anzeigeelement rahmenförmig umgibt. Dabei kann es sich um eine insbesondere rechteckige oder runde Ausnehmung handeln, durch welche das Sensorelement von dem Anzeigeelement so durchleuchtbar ist, dass die durchleuchtete Kontur bzw. die gesamte Ausnehmung in der Abdeckplatte erkennbar wird. Dies erleichtert die Bedienung der Sensortaste für den Benutzer, da die Position der Sensortaste und/oder ein Schaltzustand der Sensortaste optisch gekennzeichnet werden kann. Zudem wird eine zentrale Beleuchtung des Sensorelements möglich gemacht, ohne dessen kapazitive Funktion nennenswert zu beeinflussen. So kann vorteilhaft von einer durchgehenden metallischen Fläche, die nicht zu durchleuchten ist, abgewichen werden.

Gemäß einer vorteilhaften Ausführungsform ist an dem Lichtkasten zumindest ein Lichtschacht mit lichtdichten Wänden ausgebildet, der das Anzeigeelement optisch abschirmt. Auf diese Weise kann gewährleistet werden, dass das Anzeigeelement lediglich die ihm zugeordnete Sensortaste beleuchtet und eventuell benachbart angeordnete weitere Sensortasten von dem von dem Anzeigeelement ausgesandten Licht abgeschirmt werden. Vorteilhafterweise ist als Anzeigeelement auf der Leiterplatte innerhalb eines durch die Sensorfläche definierten Bereichs ein Leuchtelement angeordnet, wie beispielsweise eine LED, eine Glühlampe oder ein Lichtleiter. Dieses Leuchtelement kann zur Kennzeichnung der Sensorfläche oder zur Signalisierung verschiedener Schaltzustände der Sensortaste dienen. Es ist auch möglich durch geeignete Lichtführungsmittel Licht an die Position der Sensortaste zu führen und gegebenenfalls in Richtung zur Abdeckplatte umzulenken. Weiterhin kann zur Positionskennzeichnung der Sensorfläche an der Oberseite der Abdeckplatte oder bei durchsichtiger Abdeckplatte an deren Unterseite eine Markierung, z.B. in Form eines Aufdrucks angebracht sein.

Gemäß einer bevorzugten Ausführungsform weist die Bedieneinrichtung mehrere Sensortasten auf, und der Lichtkasten ist zur Fixierung mehrerer Sensorelemente ausgebildet. Durch entsprechende Lichtschächte oder -kammern bzw. Leuchtmittel lässt sich durch einen solchen Lichtkasten die unterschiedliche Beleuchtung von verschiedenen Sensortasten realisieren.

Vorzugsweise ist ein Haushaltsgerät, wie beispielsweise eine Waschmaschine, ein Wäschetrockner, eine Geschirrspülmaschine, ein Gargerät, eine Dunstabzugshaube, ein Kältegerät, ein Klimagerät, ein Warmwasserbereiter oder ein Staubsauger mit zumindest einer erfindungsgemäßen Bedieneinrichtung ausgestattet. Somit kann das Haushaltsgerät mit einer durchgängige Blende ausgestattet werden, so dass das Haushaltsgerät gegenüber einem Eintritt von Verschmutzungen oder Feuchtigkeit geschützt ist. Insbesondere entspricht die Blende der elektrisch isolierenden Abdeckplatte und kann beispielsweise aus Glas, Glaskeramik, Keramik oder Kunststoff gefertigt sein.

Es wird darauf hingewiesen, dass die Merkmale der Unteransprüche ohne Abweichung von der erfindungsgemäßen Idee in beliebiger Weise miteinander kombinierbar sind.

Anhand von Zeichnungen wird die Erfindung nachstehend näher erläutert.
- Fig. 1: zeigt eine schematische aufgebrochene Ansicht einer Ausführungsform der Bedieneinrichtung,
- Fig. 2: zeigt die Bedieneinrichtung gemäß Fig. 1 ohne Blende,
- Fig. 3: zeigt zwei Ansichten eines erfindungsgemäßen Sensorelements und
- Fig. 4: zeigt in einer schematischen Rückseitenansicht eine weitere Ausführungsform der Bedieneinrichtung in vier verschiedenen Montageschritten A, B, C und D.

Bevor auf die Zeichnungen näher eingegangen wird, sei angemerkt, dass einander entsprechende oder gleiche Elemente bzw. Einzelteile bei den verschiedenen Ausführungsformen des kapazitiven Annäherungsschalters gemäß der Erfindung in sämtlichen Zeichnungsfiguren durch gleiche Bezugszeichen bezeichnet sind.

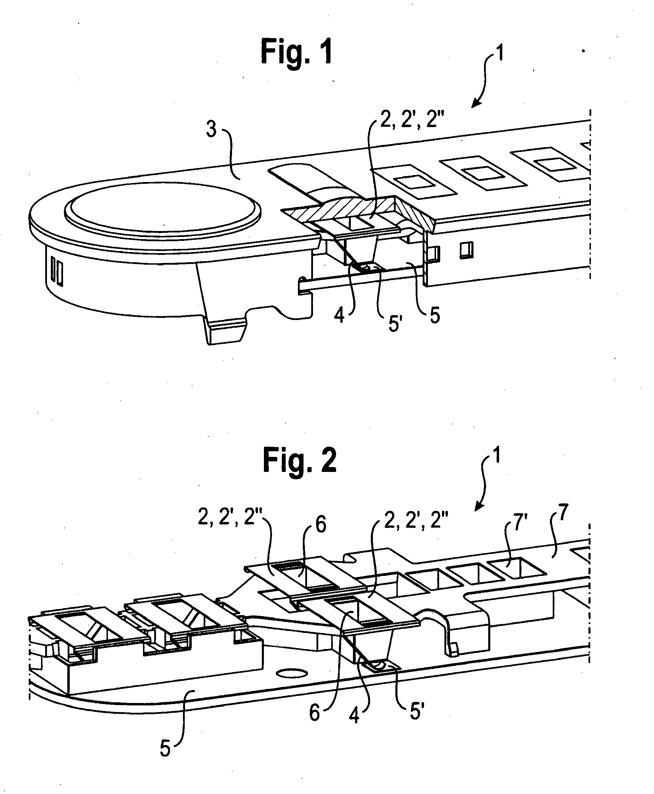

In Fig. 1 ist eine erfindungsgemäße Bedieneinrichtung 1 in Teilansicht zu erkennen. Zu sehen ist eine Blende 3, die eine in einem Abstand zu ihr angeordnete Leiterplatte 5 mit darauf angeordneten Bauteilen weitgehend überdeckt. Die Blende 3 ist als elektrisch isolierende Abdeckplatte aus einem Dielektrikum, wie beispielsweise Glas, Glaskeramik, Keramik, Kunststoff ausgebildet. Die Bedienblende 3 deutet mehrere Bedienfelder in Form von Sensortasten an, denen jeweils ein elektrisch leitfähiges Sensorelement 2 in Form einer Blattfeder zugeordnet ist, das zwischen der Blende 3 und der Leiterplatte 5 angeordnet ist und den Abstand zwischen beiden überbrückt.

In einem Ausbruch der Blende 3 ist in Figur 1 ein solches Sensorelement 2 zu erkennen. Es zeigt einen ersten im Wesentlichen ebenen Abschnitt 2', der weitgehend parallel zur Bedienblende 3 ausgebildet ist und an der Rückseite der Blende 3 anliegt. Dieser ebene Abschnitt 2' definiert mit seiner der Blende 3 zugewandten Fläche eine Sensorfläche 2". Ausgehend von dem ebenen Abschnitt 2' erstreckt sich ein Kontaktelement 4 von der Blende 3 bis zu der Leiterplatte 5, wobei das Kontaktelement 4 mit dem ebenen Abschnitt 2' einen spitzen Winkel einschließt, beispielsweise einen Winkel von etwa 45°. Insbesondere ist das Kontaktelement 4 zu dem ebenen Abschnitt 2' federnd ausgebildet, d.h. das Sensorelement 2 ist eine Blattfeder, die im eingebauten Zustand zwischen Blende 3 und Leiterplatte 5 unter Druckspannung steht. Auf diese Weise liegt das Sensorelement 2 mit seiner durch den ebenen Abschnitt 2' definierten Sensorfläche 2" plan an der Rückseite der Blende 3 und mit seinem Kontaktelement 4 an der Leiterplatte 5 an. Das Kontaktelement 4 kontaktiert dort mit seinem freien Ende eine auf der Leiterplatte 5 angeordneten Berührkontaktfläche 5', so dass eine elektrisch leitende Verbindung zwischen der Sensorfläche 2" des Sensorelements 2 und der Kontaktfläche 5' der Leiterplatte 5 besteht. Durch diese elektrisch leitende Verbindung ist die sensorische Fühlereigenschaft von der Leiterplatte 5 an die Rückseite der Blende 3 verlagert. Die Leiterplatte 5 kann insbesondere eine Kunststoffplatte sein, die auf der der Blende 3 zugewandten Plattenseite die erwähnte Kontaktfläche 5' und gegebenenfalls Leiterbahnen aufweist, über die die Kontaktfläche 5' und damit das Sensorelement 2 mit einem elektrischen Auswerteschaltkreis bzw. einer elektrischen Steuerung (nicht gezeigt) elektrisch leitend verbunden ist. Dieser Auswerteschaltkreis bzw. diese Steuerung kann ebenfalls auf der Leiterplatte 5 ausgebildet sein.

In Fig. 2 ist die Darstellung gemäß Fig. 1 ohne die aufgesetzte Blende 3 zu sehen. Zu erkennen ist dabei, dass mehrere Sensorelemente 2 vorgesehen sind, von denen zwei nebeneinander liegende näher bezeichnet sind. Jedes Sensorelement 2 weist den ebenen oberen Abschnitt 2' auf, der in seinem Zentrum von einer etwa rechteckigen Ausnehmung 6 durchbrochen wird. Jedes Sensorelement 2 wird dabei von einem gemeinsamen Lichtkasten 7 getragen bzw. örtlich fixiert.

Der Lichtkasten 7 ist dabei auf der Leiterplatte 5 so angeordnet, dass die freien Enden der jeweiligen Kontaktelemente 4 eines jeden Sensorelements 2 den zugehörigen Kontaktbereich 5' auf der Leiterplatte 5 berühren und so die elektrische Anbindung der Sensorelemente 2 herstellen. Des weiteren kann auf der Leiterplatte 5 jeweils im Bereich des Sensorelements 2 eine Lichtquelle (nicht gezeigt), wie beispielsweise eine LED, vorgesehen sein, um die Sensorfläche 2" zu kennzeichnen oder unterschiedliche Schaltzustände der Sensortaste zu signalisieren. Der Lichtkasten 7 dient gleichzeitig zur Durchleuchtung der Ausnehmungen 6 der Sensorelemente 2, wobei einzelne Lichtschächte 7' innerhalb des Lichtkastens 7 eine gezielte lokale Beleuchtung der jeweiligen Ausnehmung 6 ermöglichen. Auf diese Weise wird ein benachbart angeordnetes Sensorelement 2 gegen ungewollte Beleuchtung aus einem nicht zugehörigen Lichtschacht 7' geschützt.

In Fig. 3 ist ein erfindungsgemäßes Sensorelement 2 in zwei verschiedenen Ansichten gezeigt. Zu erkennen ist in beiden Fällen der im Wesentlichen ebene obere Abschnitt 2', der unmittelbar unterhalb der Bedienblende 3 und weitgehend parallel zu dieser zu liegen kommen soll. Der ebene Abschnitt 2' und damit die Sensorfläche 2", ist hier rechteckig ausgebildet. Es sind aber für den ebenen Abschnitt 2' und damit für die Sensorfläche 2" auch verschiedene andere Formen möglich, beispielsweise rund oder eckig, vollflächig oder rahmenförmig.

An zwei diagonal gegenüber liegenden Bereichen des ebenen Abschnitts 2' erstreckt sich jeweils ein Kontaktelement 4 unter einem Spitzenwinkel zu dem ebenen Abschnitt 2', wobei das Kontaktelement 4 an seinem freien Ende abgerundet geformt ist. Jedes Kontaktelement 4 ist federnd gegenüber dem ebenen rechteckigen Abschnitt 2' des Sensorelements 2 ausgebildet und speziell senkrecht zur Ebene dieses Grundkörpers um ein wählbares Maß nachgiebig. Durch diese Federeigenschaft wird ein sicherer, aber leicht herstellbarer bzw. lösbarer elektrischer Kontakt zwischen dem freien Ende der Kontaktelemente 4 und den Kontaktbereichen 5' auf der Leiterplatte 5 gewährleistet.

Jedes Sensorelement 2 ist von einer Ausnehmung 6 durchbrochen, die zur Durchleuchtung dient, um den Bedienbereich durch die Bedienblende 3 hindurch für den Benutzer leicht erkennbar zu machen bzw. Schaltsignale optisch anzuzeigen.

Die Sensorelemente 2 sind vorteilhaft aus einem einzigen im Wesentlichen ebenen metallischen Element herstellbar, wobei Kantenbereiche und insbesondere die Kontaktelemente 4 anschließend so umgebogen sind, dass sie unter federnder Wirkung mit der Leiterplatte 5 zusammenwirken können.

Anstatt als metallische Blattfeder kann das Sensorelement 2 aber auch andere Formen aufweisen, wie beispielsweise eine gewundene, metallische Druckfeder oder ein zylinder-, kegel- oder quaderförmiger elastischer Körper, und/oder aus anderen, elektrisch leitfähigen Materialien ausgebildet sein, wie beispielsweise aus einem elektrisch leitfähigen Kunststoff oder aus einem Kunststoff mit metallischer Seele.

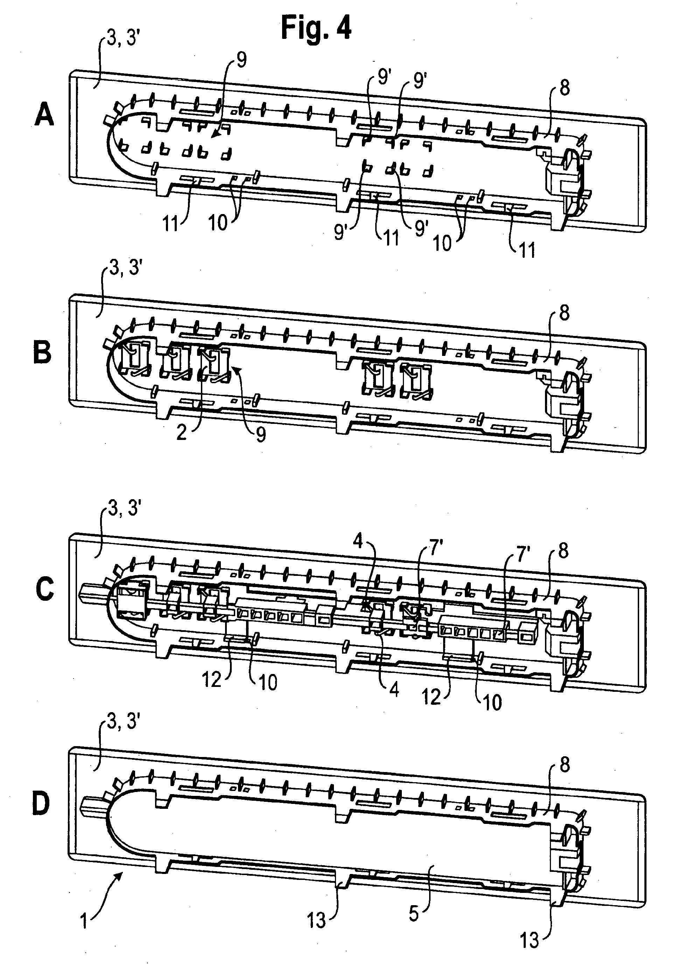

In Figur 4 ist eine weitere Ausführungsform der Bedieneinrichtung in einer perspektivischen Rückseitenansicht der Blende 3 für verschiedene Stadien A, B, C und D der Montage gezeigt. In dem ersten Montageschritt A liegt lediglich die Bedienblende 3 vor. An der Rückseite 3' der Bedienblende 3 ist ein Montagerahmen 8 einstückig angeformt, insbesondere ist dieser aus Kunststoff angespritzt. Des weiteren sind an der Rückseite 3' der Blende 3 fünf Positionierelemente 9 für je ein Sensorelement 2 angeformt, durch die die Positionen der Sensorelemente 2 an der Blendenrückseite 3' vorgegeben sind. Jedes der Positionierelemente 9 weist vier Winkel 9' auf, die einen Aufnahmerahmen für das Sensorelement 2 bilden. Des weiteren sind an dem Montagerahmen 8 erste Rastelemente 10 für die Verrastung mit dem Lichtkasten 7 und zweite Rastelemente 11 für die Verrastung mit der Leiterplatte 5 ausgebildet.

Der zweite Montageschritt B zeigt die Blende 3 mit in jedes der fünf Positionierelemente 9 eingefügtem Sensorelement 2. Jedes der Sensorelemente 2 liegt mit den Ecken seines rechteckigen, ebenen Abschnitts 2' formschlüssig in den Winkeln 9' des zugehörigen Positionierelements 9 an, so dass die Sensorelemente 2 an den durch die Positionierelemente 9 vorgegebenen Positionen an der Rückseite der Bedienblende 3 gehaltert sind. Insbesondere ist durch das Positionierelement 9 bzw. dessen Winkel 9' die Position des jeweiligen Sensorelements parallel zur Blende 3 festgelegt, so dass lediglich ein Translationsfreiheitsgrad senkrecht zur Blende 3 übrig bleibt.

Das dritte Montagestadium C zeigt die Blende 3 mit an der Blendenrückseite 3' montiertem Lichtkasten 7. Dazu weist der Lichtkasten 7 seinerseits Rastelemente 12 auf, die mit den ersten Rastelementen 10 des Montagerahmens 8 verrastet sind. Durch die Montage des Lichtkastens 7 an der Rückseite 3' der Blende 3 werden die Sensorelemente 2 in ihrer durch die Positionierelemente 9 vorgegebene Position an der Blendenrückseite 3' fixiert. Die Sensorelemente 2 sind nun mit ihrem ebenen Abschnitt 2' zwischen der Blendenrückseite 3' und dem Lichtkasten 7 gehaltert, so dass eine Positionsverschiebung der Sensorelemente 2 in keine Richtung mehr möglich ist. Die Kontaktelemente 4 jedes Sensorelements 2 ragen durch einen jeweils von einem Winkel 9' des Positionierbereichs 9 und dem Lichtkasten 7 gebildeten Zwischenraum und erstrecken sich von der Rückseite 3' der Blende 3 weg. Des weiteren sind an dem Lichtkasten 7 diverse Lichtschächte 7' ausgebildet, so dass ein Lichtfluss von einem Leuchtelement (nicht gezeigt) der Leiterplatte 5 bis zu der Bedienblende 3 möglich ist. Die Bedienblende 3 ist transparent oder transluzent ausgebildet oder weist zumindest an den Positionen der Leuchtelemente entsprechende transparente oder transluzente Einsätze auf.

Das vierte Montagestadium D zeigt die Bedieneinrichtung 1 mit montierter Leiterplatte 5. Dazu ist die Leiterplatte 5 mit den zweiten Rastelementen 11 des Montagerahmens 8 verrastet, wobei die Kontaktelemente 4 der Sensorelemente 2 unter Federspannung gesetzt sind. Durch diese Feder- oder Druckspannung ist der elektrische Kontakt zwischen den Kontaktelementen 4 und den Berührkontaktflächen 5' der Leiterplatte 5 gewährleistet. Die Leiterplatte 5 bildet zusammen mit dem Montagerahmen 8 und der Blende 3 ein Gehäuse für die auf der Leiterplatte 5 angeordneten Elektronikbauteile, so dass diese gegenüber Umwelteinflüssen geschützt sind. Weiterhin sind an dem Montagerahmen 8 dritte Rastelemente 13 ausgebildet, durch die eine einfache Befestigung der Bedieneinrichtung 1 in einem Aufnahmeraum eines Haushaltsgerätes möglich ist.

In einer alternativen Ausführungsform (nicht gezeigt) können anstelle des oben gezeigten zweiten Montageschritts B die Sensorelemente 2 zuerst an dem Lichtkasten 7 fixiert werden. Dafür kann an dem Lichtkasten 7 eine Halterung für jedes der Sensorelemente 2 vorgesehen sein. Diese Halterung kann beispielsweise dadurch gebildet sein, dass die Winkel 9' der Positionierelemente 9 gemäß Figur 4 A und B anstatt an der Blendenrückseite 3' an dem Lichtkasten 7 ausgebildet sind. Dabei können Öffnungen in dem Lichtkasten 7 erhalten bleiben, durch die sich die Kontaktelemente 4 der Sensorelemente 2 erstrecken. Durch die Anordnung der Kontaktelemente 4 zu dem ebenen Abschnitt 2' des Sensoreklements 2 unter einem spitzen Winkel, können die Sensorelemente 2 in die Halterungen des Lichtkastens 7 "eingeklippst" werden und sind auf diese Weise an dem Lichtkasten 7 fixiert. In dem dritten Montageschritt C wird dann der mit den Sensorelementen 2 bereits bestückte Lichtkasten 7 an dem Montagerahmen 8 montiert. Alternativ dazu kann der Lichtkasten 7 auch zuerst mit der Leiterplatte 5 verbunden und diese vormontierte Baugruppe danach an dem Montagerahmen 8 oder direkt an der Blende 3 montiert werden. Die zugehörigen Rastelemente können dafür an der Leiterplatte 5 und/oder an dem Lichtkasten 7 ausgebildet sein.

### Bezugszeichenliste

- 1: Bedieneinrichtung
- 2: Sensorelement
- 2': ebener Abschnitt
- 2": Sensorfläche
- 3: Blende
- 3': Rückseite der Blende
- 4: Kontaktelement
- 5: Leiterplatte
- 5': Berührkontaktfläche
- 6: Ausnehmung
- 7: Lichtkasten
- 7': Lichtschacht
- 8: Montagerahmen
- 9: Positionierelement
- 9': Winkel des Positionierelements
- 10: erste Rastelemente des Montagerahmens
- 11: zweite Rastelemente des Montagerahmens
- 12: Rastelemente des Lichtkastens
- 13: dritte Rastelemente des Montagerahmens

## Patentansprüche

1. Bedieneinrichtung für ein Haushaltsgerät mit zumindest einer kapazitiven Sensortaste, wobei die Sensortaste ein elektrisch leitfähiges Sensorelement (2) mit einer Sensorfläche (2") aufweist, mit der dieses Sensorelement (2) an einer Rückseite einer elektrisch isolierenden Abdeckplatte (3) der Bedieneinrichtung (1) anliegt, wobei in einem Abstand von der Abdeckplatte (3) eine Leiterplatte (5) angeordnet ist, und wobei sich das Sensorelement (2) von der Abdeckplatte (3) bis zu der Leiterplatte (5) erstreckt, wobei zwischen der Abdeckplatte (3) und der Leiterplatte (5) ein Lichtkasten (7) angeordnet ist, durch den das Sensorelement (2) in einer vorgegebenen Position an der Rückseite der Abdeckplatte (3) parallel und senkrecht zu der Abdeckplatte (3) fixiert ist, wobei an dem Lichtkasten (7) zumindest eine Halterung für das Sensorelement (2) ausgebildet ist, mit der das Sensorelement (2) gehaltert ist, wobei die Fixierung des Sensorelements (2) allein durch die an dem Lichtkasten (7) ausgebildete Halterung realisiert ist, **dadurch gekennzeichnet, dass** die Halterung ein Rastelement ist, mit dem das Sensorelement (2) verrastet ist.

2. Bedieneinrichtung nach Anspruch 1, **dadurch gekennzeichnet, dass** der Lichtkasten (7) und die Abdeckplatte (3) und/oder der Lichtkasten (7) und die Leiterplatte (5) und/oder die Leiterplatte (5) und die Abdeckplatte (3) durch eine Rastverbindung (10, 11, 12) miteinander verbunden sind.

3. Bedieneinrichtung nach einem der vorhergehenden Ansprüche, **dadurch gekennzeichnet, dass** an der Abdeckplatte (3) ein Montagerahmen (8) angeformt ist, an dem der Lichtkasten (7) und/oder die Leiterplatte (5) mittels Rastverbindung (10, 11, 12) montiert ist.

4. Bedieneinrichtung nach einem der vorhergehenden Ansprüche, **dadurch gekennzeichnet, dass** das Sensorelement (2) lediglich über Druckspannung an einer Berührkontaktfläche (5') der Leiterplatte (5) anliegt.

5. Bedieneinrichtung nach einem der vorhergehenden Ansprüche, **dadurch gekennzeichnet, dass** das Sensorelement (2) eine metallische Blattfeder oder eine aus einem gestreckten Körper gewundene Druckfeder oder ein elastischer Körper aus Leitgummi ist.

6. Bedieneinrichtung nach einem der vorhergehenden Ansprüche, **dadurch gekennzeichnet, dass** die Abdeckplatte (3) zumindest teilweise lichtdurchlässig ausgebildet ist, und dass auf der Leiterplatte (5) im Bereich der Sensorfläche (2") ein optisches Anzeigeelement angeordnet ist.

7. Bedieneinrichtung nach Anspruch 6, **dadurch gekennzeichnet, dass** das Sensorelement (2) zumindest einen Durchlass (6) für Licht des Anzeigeelements aufweist.

8. Bedieneinrichtung nach einem der Ansprüche 6 oder 7, **dadurch gekennzeichnet, dass** an dem Lichtkasten (7) zumindest ein Lichtschacht (7') mit lichtdichten Wänden ausgebildet ist, der das Anzeigeelement optisch abschirmt.

9. Bedieneinrichtung nach einem der vorhergehenden Ansprüche, **dadurch gekennzeichnet, dass** der Lichtkasten (7) zur Fixierung mehrerer Sensorelemente (2) ausgebildet ist.

10. Haushaltsgerät mit einer Bedieneinrichtung (1) nach einem der Ansprüche 1 bis 9.

## Claims

1. Control device for a household appliance having at least one capacitive sensor key, wherein the sensor key has an electrically conductive sensor element (2) that has a sensor surface (2") with which said sensor element (2) is applied against a rear side of an electrically insulating cover plate (3) of the control device (1), wherein a printed circuit board (5) is arranged at a distance from the cover plate (3) and wherein the sensor element (2) extends from the cover plate (3) to the printed circuit board (5), wherein arranged between the cover plate (3) and the printed circuit board (5) is a light box (7) by means of which the sensor element (2) is fixed into a predefined position on the rear side of the cover plate (3) parallel and perpendicular to the cover plate (3), wherein at least one mount for the sensor element (2) by means of which the sensor element (2) is held in position is embodied on the light box (7), wherein the sensor element (2) is fixed into position solely by the mount embodied on the light box (7), **characterised in that** the mount is a snap-in element by means of which the sensor element (2) is snapped into position.

2. Control device according to claim 1, **characterised in that** the light box (7) and cover plate (3) and/or the light box (7) and the printed circuit board (5) and/or the printed circuit board (5) and the cover plate (3) are connected to each other by means of a snap-in connection (10, 11, 12).

3. Control device according to one of the preceding claims, **characterised in that** moulded onto the cover plate (3) is a mounting frame (8) onto which the light box (7) and/or the printed circuit board (5) have/has been mounted by means of a snap-in connection (10, 11, 12).

4. Control device according to one of the preceding claims, **characterised in that** the sensor element (2) is applied against a touch-contact surface (5') of the printed circuit board (5) only via compressive tension.

5. Control device according to one of the preceding claims, **characterised in that** the sensor element (2) is a metallic leaf spring or a compression spring wound from a stretched body or an elastic body made of conductive rubber.

6. Control device according to one of the preceding claims, **characterised in that** the cover plate (3) is embodied as being at least partially translucent and **in that** an optical display element is arranged on the printed circuit board (5) in the region of the sensor surface (2").

7. Control device according to claim 6, **characterised in that** the sensor element (2) has at least one passage (6) for light from the display element.

8. Control device according to one of claims 6 or 7, **characterised in that** at least one light shaft (7') that has light-tight walls and optically screens the display element is embodied on the light box (7).

9. Control device according to one of the preceding claims, **characterised in that** the light box (7) is embodied for fixing a plurality of sensor elements (2) into position.

10. Household appliance having a control device (1) according to one of claims 1 to 9.

## Revendications

1. Dispositif de commande pour un appareil ménager, comprenant au moins une touche à effleurement capacitive, la touche à effleurement présentant un élément capteur (2) électroconducteur muni d'une surface de capteur (2"), avec laquelle cet élément capteur (2) est adjacent à un côté arrière d'une plaque de recouvrement (3), isolant électriquement, du dispositif de commande (1), une plaquette à circuit imprimé (5) étant disposée avec un écart de la plaque de recouvrement (3), et l'élément capteur (2) s'étendant de la plaque de recouvrement (3) jusqu'à la plaquette à circuit imprimé (5), une boîte à lumière (7) étant disposée entre la plaque de recouvrement (3) et la plaquette à circuit imprimé (5), au moyen de laquelle boîte à lumière l'élément capteur (2) est fixé parallèlement et verticalement par rapport à la plaque de recouvrement (3) dans une position prédéfinie sur le côté arrière de la plaque de recouvrement (3), au moins un support pour l'élément capteur (2) étant réalisé sur la boîte à lumière (7), au moyen duquel support l'élément capteur (2) est maintenu, la fixation de l'élément capteur (2) étant réalisée uniquement au moyen du support réalisé sur la boîte à lumière (7), **caractérisé en ce que** le support est un élément d'encliquetage à l'aide duquel l'élément capteur (2) est encliqueté.

2. Dispositif de commande selon la revendication 1, **caractérisé en ce que** la boîte à lumière (7) et la plaque de recouvrement (3) et/ou la boîte à lumière (7) et la plaquette à circuit imprimé (5) et/ou la plaquette à circuit imprimé (5) et la plaque de recouvrement (3) sont reliées entre elles au moyen d'une liaison par encliquetage (10, 11, 12).

3. Dispositif de commande selon l'une quelconque des revendications précédentes, **caractérisé en ce qu'**un cadre de montage (8) est formé sur la plaque de recouvrement (3), sur lequel la boîte à lumière (7) et/ou la plaquette à circuit imprimé (5) sont montées au moyen de la liaison par encliquetage (10, 11, 12).

4. Dispositif de commande selon l'une quelconque des revendications précédentes, **caractérisé en ce que** l'élément capteur (2) est adjacent à une surface de contact d'affleurement (5') de la plaquette à circuit imprimé (5) uniquement par contrainte de pression.

5. Dispositif de commande selon l'une quelconque des revendications précédentes, **caractérisé en ce que** l'élément capteur (2) est un ressort feuilleté métallique ou un ressort de compression tordu à partir d'un corps allongé ou un corps élastique en caoutchouc conducteur.

6. Dispositif de commande selon l'une quelconque des revendications précédentes, **caractérisé en ce que** la plaque de recouvrement (3) est réalisée au moins en partie de manière perméable à la lumière, et **en ce qu'**un élément d'affichage optique est disposé sur la plaquette à circuit imprimé (5) dans la zone de la surface de capteur (2").

7. Dispositif de commande selon la revendication 6, **caractérisé en ce que** l'élément capteur (2) présente au moins un passage (6) pour la lumière de l'élément d'affichage.

8. Dispositif de commande selon l'une quelconque des revendications 6 ou 7, **caractérisé en ce qu'**au moins un puits de lumière (7') muni de parois étanches à la lumière est réalisé sur la boîte à lumière (7), lequel puits de lumière protège l'élément d'affichage optiquement.

9. Dispositif de commande selon l'une quelconque des revendications précédentes, **caractérisé en ce que** la boîte à lumière (7) est réalisée pour la fixation de plusieurs éléments capteurs (2).

10. Appareil ménager muni d'un dispositif de commande (1) selon l'une quelconque des revendications 1 à 9.
